# EUROPEAN PATENT APPLICATION

(11) **EP 4 576 172 A1**
(43) Date of publication of application: **25.06.2025**
(21) Application number: 24179113.6
(22) Date of filing: 30.05.2024
(51) Int. Cl.: H01L 21/3065

(54) **METHODS OF TREATING A SEMICONDUCTOR SUBSTRATE AND APPARATUS**

(30) Priority: 22.12.2023 GB 202319985
(71) Applicant: SPTS Technologies Limited, Newport Gwent NP18 2TA (GB)
(72) Inventor: Bond, Eloise, Newport (GB)
(74) Representative: Wynne-Jones IP Limited

(57) **Abstract**

According to the invention there is provided a method of treating a semiconductor substrate, the semiconductor substrate having an etched feature comprising a sidewall with a scalloped profile, the method comprising the steps of:
placing the semiconductor substrate on a substrate support in an etch chamber, the semiconductor substrate having an etched feature comprising a sidewall with a scalloped profile; and
performing a treatment step by generating a plasma in a gaseous atmosphere comprising Ar, O₂ and at least one per-fluorocarbon while applying an RF signal having an RF power to the substrate support, wherein the plasma (i) causes a protective layer formed at least partially from the per-fluorocarbon to be deposited on the sidewall and (ii) etches the sidewall so as to smooth the scalloped profile of the sidewall.

## Description

### Field of the Disclosure

This invention relates to method of treating a semiconductor substrate, with particular reference to semiconductor substrates having an etched feature comprising a sidewall with a scalloped profile. The invention relates also to an associated apparatus.

### Background of the Disclosure

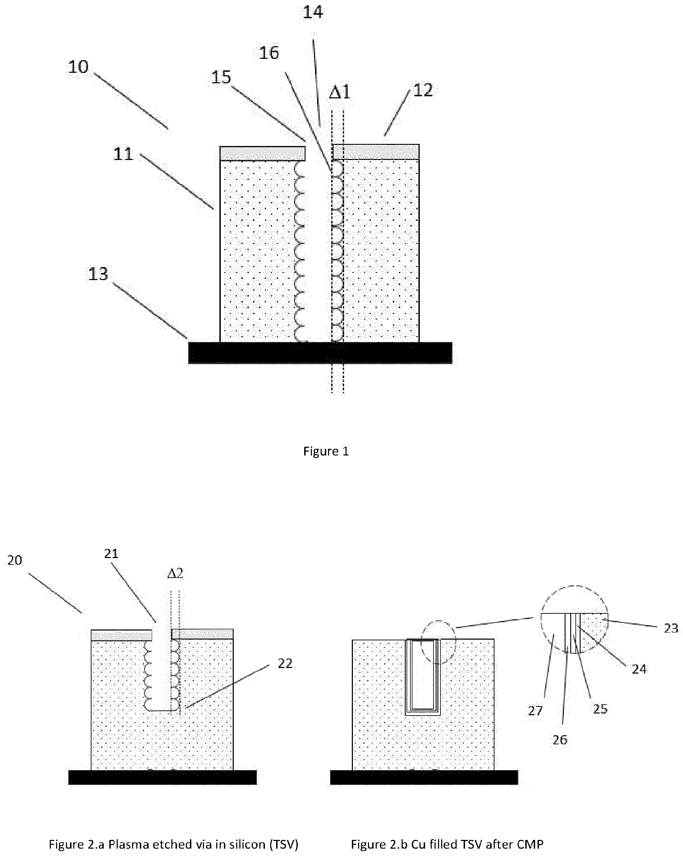

The so-called `Bosch process' for etching silicon was proposed in US patent no. 6127273 and has been the subject of considerable development since. The process enables a high etch rate to be achieved when etching features such as silicon trenches and vias. This is particularly significant for deep etch features (greater than 10mm depth), where conventional anisotropic non-cyclic etch rates would be impractical. The Bosch process is a cyclic process with an isotropic etch cycle, a polymer passivation cycle and, in some implementations, a breakthrough step which is repeated until the required depth is achieved. "Scallops" are formed on the sides of the feature at the transition from one cycle to the next. Figure 1 is a schematic representation 10 of an etched feature in silicon using the Bosch process. The silicon wafer 11 has a mask 12, which could be photoresist, a laser grooved coating or a hardmask, and is supported on tape attached to a frame or a carrier wafer 13. Opening 15 in the mask enables the plasma etching process to localize the etch process and produce 14 the feature required. The scallops 16 are present on the sidewall of the etched feature. The cyclical Bosch produces a series of isotropic cavities which can be viewed as having "peaks" and "valleys". The height of the scallops is defined by the distance between the peaks and valleys, designated as Δ1. Δ1 could typically be ~50- 200nm. In general faster etch rates are produced by employing a longer isotropic etch step duration which results in larger scallops. While in some applications scallops are acceptable, such as many MEMs devices or plasma diced wafers, there are many cases where the size of the scallops is problematic.

In many applications when there are subsequent process steps such as in through silicon vias (TSVs) where a smooth surface is required to aid step coverage and Cu fill or plasma diced wafers where defectivity control is critical it is desirable for the scallop size to be as small as possible. In hybrid or fusion bonding applications extremely clean surfaces are required for successful bonding and the sharp points on scallops provide a source of particulate. For example, Figure 2 shows a through silicon via (TSV) formation process in which (Figure 2(a)) a via 21 is etched into silicon through a mask. The etch process is stopped at a depth 22. Via diameter can vary from 1-10 microns with aspect ratios of up to 20:1. Figure 2(b) shows the via after subsequent processing in which the via is filled with copper 27 by ECD (electrochemical deposition). It is desirable for the sidewalls of the feature to be as smooth as possible prior to the deposition of a CVD dielectric layer 23, a barrier layer 24 and a PVD copper seed layer 25. Figure 2(b) is a schematic representation of the TSV following the removal of the films on the surface of the wafer by CMP (Chemical-Mechanical Polishing). In this case, particularly with high aspect ratio features, there is a requirement that the scallops are as small as possible, for example less than 50nm. Conventional Bosch processing, even operating at low etch rates, produces a Δ2 which is not acceptable for the subsequent processing steps. Typically Δ2 < Δ1.

Additionally, the present inventors have realized that there could be productivity benefits if a smoothing step could be applied to reduce the size of large scallops. High silicon etch rates are associated with increased scallop size (since the isotropic etch step is extended). If a rapid smoothing step could be provided then it is possible that productivity benefits could also be achieved in certain applications where the time taken to perform the smoothing step is outweighed by the reduced etch time achieved using longer isotopic etch steps.

### Statement of Invention

What is required is a method of smoothing the scallops. It is desirable to significantly remove or reduce the size of scallops formed following a Bosch type silicon etch process. It would be desirable for the smoothing to be performed provided in the same system as is used to carry out the Bosch etch process.

According to a first aspect of the invention there is provided a method of treating a semiconductor substrate, the semiconductor substrate having an etched feature comprising a sidewall with a scalloped profile, the method comprising the steps of:
placing the semiconductor substrate on a substrate support in an etch chamber, the semiconductor substrate having an etched feature comprising a sidewall with a scalloped profile; and
performing a treatment step by generating a plasma in a gaseous atmosphere comprising Ar, O₂ and at least one per-fluorocarbon while applying an RF signal having an RF power to the substrate support, wherein the plasma (i) causes a protective layer formed at least partially from the per-fluorocarbon to be deposited on the sidewall and (ii) etches the sidewall so as to smooth the scalloped profile of the sidewall.

There are numerous benefits associated with the invention including a reduction in sharp and rough scallop points that may be seen as defects by inspection metrology. Also, the smoother sidewall profile allows more conformal deposition to take place in post-etch processing steps. Further still, the desire for small scallops often limits the process window available for processing in prior art methodologies. The invention allows larger scallops to be formed in the main etch process and reduced afterwards by the smoothing step. Etch processes that produce larger scallops normally have a larger process window and a faster etch rate. Both of these attributes are highly desirable.

The treatment step can be performed with a pressure in the etch chamber in the range 100 to 300 mTorr. The treatment step can be performed with a pressure in the etch chamber in the range 150 to 250 mTorr. The use of such relatively high pressures is advantageous because it can help to promote a conformal deposition of the protective layer on the sidewalls. In principle, it is possible to use lower pressures, at least at the start of a smoothing process. For example, an etch apparatus might be used which has a plasma generating device additional to the RF driven substrate support, such as an ICP (inductively coupled plasma) plasma generating device. At least the start of a smoothing process might be run at a lower pressure using the ICP plasma generating device.

The treatment step can be performed using an RF power in the range 1,500W to 5,000W. The treatment step can be performed using an RF power in the range 2,500W to 4,000W.

The at least one per-fluorocarbon is of general formula CₓF_{y}. The at least one per-fluorocarbon can comprise one or more per-fluoro alkane, per-fluoro cycloalkane, per-fluoro alkene and/or per-fluoro cycloalkene. The at least one fluorocarbon can comprise one or more of C₄F₈, C₅F₈ and C₄F₆. Other per-fluorocarbon species might be used, provided they are gaseous or have a sufficiently high vapour pressure.

The treatment step can be performed in a gaseous atmosphere consisting essentially of Ar, O₂ and at least one per-fluorocarbon.

The treatment step can be performed with Ar being introduced into the etch chamber at a flow rate in the range 100 to 500 sccm. The treatment step can be performed with Ar being introduced into the etch chamber at a flow rate in the range 250 to 350 sccm.

The treatment step can be performed with O₂ being introduced into the etch chamber at a flow rate in the range 30 to 100 sccm. The treatment step can be performed with O₂ being introduced into the etch chamber at a flow rate in the range 50 to 80 sccm.

The treatment step can be performed with the at least one fluorocarbon being introduced into the etch chamber at a flow rate in the range 25 to 50 sccm.

The treatment step is performed with the substrate support maintained at a temperature in the range 0 to 20°C.

The semiconductor substrate can be a silicon substrate. The semiconductor substrate can be a wafer, such as a silicon wafer.

The etched feature can be a via, a trench and/or an etched feature having a depth of 10 microns or greater. The etched feature can have an aspect ratio of 10:1 or greater. The etched feature can have an aspect ratio of 15:1 or greater.

The semiconductor substrate can have a mask formed on a surface thereof, the mask having an aperture which defines an opening of the etched feature. The mask can be of any suitable type, such as photoresist, hard mask or a laser grooved coating.

The protective layer can be a polymer.

The scalloped profile can comprise a plurality of scallops each having an associated height, and the smoothing of the scalloped profile of the sidewall can comprise reducing the heights of the scallops. A scallop height is (as shown in Figure 1) the difference in length between the tip of a scallop and the base of the scallop along a line which is perpendicular to a plane defined by the bases of the scallops, the line intersecting the scallop tip. The heights of the scallops can be reduced by at least 50%. The heights of the scallops can be reduced by at least 75%. The heights of the scallops can be reduced by at least 90%.

It is an advantage of the invention that the apparatus which is used to etch the feature can be used to perform the treatment step.

The method can be performed using the RF signal as the only plasma generation source. For example, the apparatus might either not be provided with a supplementary plasma generation source (such as an ICP) or the supplementary plasma generation source might be switched off during smoothing.

According to a second aspect of the invention there is provided a method of etching and treating a semiconductor substrate comprising the steps of:
placing the semiconductor substrate on a substrate support in an etch chamber;
performing an etch step by generating a plasma and using the plasma to etch a feature in the semiconductor substrate, the etched feature comprising a sidewall with a scalloped profile; and
performing a treatment step by generating a plasma in a gaseous atmosphere comprising Ar, O₂ and at least one per-fluorocarbon while applying an RF signal having an RF power to the substrate support, wherein the plasma (i) causes a protective layer formed at least partially from the per-fluorocarbon to be deposited on the sidewall and (ii) etches the sidewall so as to smooth the scalloped profile of the sidewall.

The method can comprise the further steps of:
performing a second etch step by generating a plasma and using the plasma to deepen the etched feature by etching a further section deeper into the semiconductor substrate, the further section comprising a sidewall with a scalloped profile; and
performing a second treatment step by generating a plasma in a gaseous atmosphere comprising Ar, O₂ and at least one per-fluorocarbon while applying an RF signal having an RF power to the substrate support, wherein the plasma (i) causes a protective layer formed at least partially from the per-fluorocarbon to be deposited on the sidewall of the further section and (ii) etches the sidewall of the further section so as to smooth the scalloped profile of the sidewall of the further section.

The steps of performing a second etch step and performing a second treatment step can be alternated.

In practice, the etch step and, when performed, the second etch step are all likely to be Bosch type etch processes where an isotropic etch cycle, a sidewall passivation cycle and, optionally, a more anisotropic breakthrough step are performed cyclically.

It is an advantage of the invention that the apparatus which is used to etch the feature can be used to perform the smoothing step.

According to a third aspect of the invention there is provided an etch apparatus for treating a semiconductor substrate comprising:
an etch chamber;
a substrate support in the etch chamber;
an RF source configured to supply an RF signal having an RF power to the substrate support;
at least one inlet for introducing a plurality of gases into the etch chamber; and
a controller configured to control the apparatus to perform a method according to any previous claim.

The apparatus can further comprise a plasma production device which is additional to the RF source. The plasma production device can be an ICP plasma production device.

For the avoidance of doubt, whenever reference is made herein to 'comprising' or 'including' and like terms, the invention is also understood to include more limiting terms such as 'consisting' and `consisting essentially'. For the avoidance of doubt, whenever two ranges are provided herein for a parameter, each having an upper and a lower bound, the invention discloses also other sub-ranges made up of all possible combinations of the bounds explicitly disclosed herein. As discussed herein, different sub-ranges allow various properties of the smoothing to be fine-tuned.

Whilst the invention has been described above, it extends to any inventive combination of the features set out above, or in the following description, drawings or claims. For the avoidance of doubt, any features disclosed in relation to the first and second aspects of the invention may be combined with any features disclosed in relation to the third aspect of the invention and *vice versa* as appropriate.

### Description of the Drawings

Embodiments of the invention will now be described, by way of example only, with reference to the accompanying drawings, in which:
Figure 1 is a cross sectional view of plasma etched trench in a silicon substrate; and
Figure 2 shows cross sectional views of (a) a plasma etched via (TSV) in a silicon substrate and b) the TSV after CMP and filling with Cu.

### Detailed Description of the Disclosure

The present invention provides a technique for smoothing semiconductor substrates having an etched feature comprising a sidewall with a scalloped profile. The invention can be implemented in a wide variety of etch apparatus having the capability to apply an RF power to a substrate support. An example of a commercial etch apparatus which can be adapted to perform a method of the invention is a Rapier^{™} 300S etch chamber (SPTS Technologies Limited, Newport, UK). Smoothing of scalloped sidewalls has been performed in an etch chamber of this type using an Ar, O₂ and C₄F₈ environment with an RF driven (13.56MHz) substrate support. The substrate support comprises a thick ceramic monopolar electrostatic chuck (ESC) which is cooled to about 0-20°C using a 'backside' pressure of He which is supplied to the ESC in a manner well known to the skilled reader. Table 1 shows representative process conditions for the scallop smoothing process. Excellent scallop removal was achieved with RF bias powers up to 3kW. The etch rate was strongly dependent on RF bias power. There are various etch constituents, parameters and factors which influence the outcome of the smoothing process. For example, a high bias power enables high energy ion bombardment of the wafer, while the relatively high pressure used (100-300mTorr) helps to promote a conformal polymer deposition on the sidewalls from the dissociation of C₄F₈. Ar is present as a sputtering gas to physically remove material from the scallop tips and in turn expose portions of silicon. Oxygen also assists in removing polymer from the tips of the scallops and to provide a source of F for etching silicon. While there is some Ar sputter etching of the tips of the scallops, fluorine released from the dissociation of C₄F₈ increases the etch rate by chemically etching the silicon. Similar results can be achieved with other CₓF_{y} gases or with C₄F₈ in combination with other CₓF_{y} gases.

**Table 1. Process conditions for smoothing of scallops.**

| Parameter | Range | Typical |
|---|---|---|
| Pressure (mTorr) | 100 to 300 | 150 |
| Platen (kW) | 1.5 to 5 | 3 |
| Ar (sccm) | 100 to 500 | 300 |
| O₂ (sccm) | 30 to 100 | 65 |
| C₄F₈ (sccm) | 10 to 70 | 35 |
| | | |
| He (Torr) | 2.5 to 10 | 8 |
| ESC (kV) | 3 to 10 | 6 |
| Temperature (°C) | 0 to 20 | 3 |

A discussion of general trends associated with various factors in the smoothing process is now presented. Although the discussion is not exhaustive, it will be appreciated that it assists the skilled reader to vary the process conditions used in a smoothing step to improve the outcome for any given application. The balance of gas flows can be changed to vary the rate at which scallops are reduced. Increasing the C₄F₈ flow rate and reducing the O₂ flow rate results in enhanced polymer formation underneath the scallops, giving better protection for the 'true' etch sidewall (i.e. the surface left after smoothing processing has been completed). Alternatively decreasing the C₄F₈ flow rate and increasing the O₂ flow rate increases the rate of isotropic etching, resulting in greater scallop removal as more polymer is removed by the oxygen. This could be beneficial in applications in which polymer otherwise remains on the sidewall after the initial etch process. A decrease in C₄F₈ flow rate increases selectivity to oxides. This is frequently beneficial as many applications have an oxide stop layer which should be preserved. Varying the flow of argon changes the physicality of the etch. The effect of the argon is chiefly directed to the tips of the scallops and therefore argon is useful for smoothing smaller scallops without damaging the 'true' sidewall. Increasing RF bias increases the effectiveness of smoothing. Higher RF powers are favored for fast scallop removal and for higher selectivity to photoresist masks. However, if the feature has an oxide stop layer, then a lower RF power over an extended process time may be used to reduce the loss of oxide. The total pressure affects how conformally the protective layer coats the scallops. Variation of the pressure can change how the scallop underside and 'true' sidewall are protected.

### Experimental Results

Experiments were carried out on 300mm silicon wafers on taped wafer carriers (400mm) in the SPTS Rapier^{™} 300S chamber. It is possible to place a wafer *per se* onto the substrate support instead of a wafer/ tape/ carrier assembly. The Rapier etch tool is supplied with an ICP plasma generator, but the experiments discussed herein were performed without using the ICP source power. In other words, the Rapier tool was run in RIE mode with plasma generated only by the RF power supplied to the wafer support. No ashing or polymer strip step was carried out prior to the smoothing step. Scallop size was determined by SEM measurements. The silicon wafers had a photoresist mask deposited thereon and a layer of SiOz layer of about 3mm thickness beneath the silicon. Silicon thickness varied between 50-90mm.

Table 2 shows the reduction in scallop height as a function of platen power. A strong dependence is observed of the scallop etch rate on RF platen power, where a 4.3x increase in platen power provides a 6x increase in etch rate.

**Table 2. Scallop Reduction as a function of platen RF power.**

| Platen power (Watts) | Time (min) | Scallop measurement (nm) |
|---|---|---|
| 0 | | 250 |
| 700 | 45 | 0 |
| 3000 | 7.5 | 0 |

The heights of the scallops in a sidewall can change within the etched feature, particularly if the length of the isotropic etch is varied during the etching of the feature. Table 3 shows the influence of scallop size on smoothing time in such an instance where the scallop size changes within an etched trench. Near the opening of the mask at the top of the trench a scallop size of about 327nm is produced, whereas the etch rate was increased to produce a larger scallop of about 934nm height further from the top of the trench). Even larger scallops of about 1235nm height were produced close to an oxide layer at the bottom of the trench. All of the initial scallops are considerably larger than those addressed in Table 2. However, after 3 minutes of smoothing even the deepest scallops at the bottom of the trench were reduced by 90% in height. As the process is extended there is some oxide loss.

**Table 3. Scallop reduction values for variable scallop sizes in a trench.**

| Smoothing time (min) | Top small (nm) | | Top Large (nm) | | Bottom (nm) | | Oxide Loss (µm) |
|---|---|---|---|---|---|---|---|
| 0 | 327 | | 934 | | 1235 | | |
| 1 | N/A | -100% | 280 | -66% | 208 | -83% | Not measured |
| 2 | N/A | -100% | 178 | -79% | N/A | -100% | 0.3 |
| 3 | N/A | -100% | 144 | -83% | 124 | -90% | 0.5 |

The smoothing steps in the examples described above were conducted on fully formed plasma etch trenches. In alternative implementations, the smoothing process can be run during the feature etch process. Ideally, the same etch module runs both the etch step and the smoothing step, although in principle two chambers could be used. It is an advantage of the invention that both etch and smoothing steps can be readily performed in a single etch apparatus. In one such variant an initial etch step is performed to an intermediate etch depth followed by a smoothing step. Then a second etch step is performed to reach the full etch depth followed by a final smoothing step. In other variants still, more than two etch steps are performed, each etch step followed by a smoothing step. The nature of the mask needs to be considered for this approach, particularly with a photoresist mask as the smoothing step will consume some of the mask. However, the precepts provided above will enable the skilled reader to adapt the smoothing process to suit a given application. This approach could be beneficial if, for example, there are concerns about loss of substrate during a final smoothing step, such as when landing on a thin SiOz layer or sensitive dicing tape.

## Claims

1. A method of treating a semiconductor substrate, the semiconductor substrate having an etched feature comprising a sidewall with a scalloped profile, the method comprising the steps of:
placing the semiconductor substrate on a substrate support in an etch chamber, the semiconductor substrate having an etched feature comprising a sidewall with a scalloped profile; and
performing a treatment step by generating a plasma in a gaseous atmosphere comprising Ar, O₂ and at least one per-fluorocarbon while applying an RF signal having an RF power to the substrate support, wherein the plasma (i) causes a protective layer formed at least partially from the per-fluorocarbon to be deposited on the sidewall and (ii) etches the sidewall so as to smooth the scalloped profile of the sidewall.

2. A method according to claim 1 in which the treatment step is performed with a pressure in the etch chamber in the range 100 to 300 mTorr.

3. A method according to claim 1 or claim 2 in which the treatment step is performed using an RF power in the range 1,500W to 5,000W.

4. A method according to any one of claims 1 to 3 in which the at least one fluorocarbon comprises one or more of C₄F₈, C₅F₈ and C₄F₆.

5. A method according to any previous claim in which the treatment step is performed in a gaseous atmosphere consisting essentially of Ar, O₂ and at least one per-fluorocarbon.

6. A method according to any previous claim in which the treatment step is performed with Ar being introduced into the etch chamber at a flow rate in the range 100 to 500 sccm.

7. A method according to any previous claim in which the treatment step is performed with O₂ being introduced into the etch chamber at a flow rate in the range 30 to 100 sccm.

8. A method according to any previous claim in which the treatment step is performed with the at least one fluorocarbon being introduced into the etch chamber at a flow rate in the range 10 to 70 sccm.

9. A method according to any previous claim in which the treatment step is performed with the substrate support maintained at a temperature in the range 0 to 20°C.

10. A method according to any previous claim in which the semiconductor substrate is a silicon substrate; and/or the etched feature is a via, a trench and/or an etched feature having a depth of 10 microns or greater; the semiconductor substrate has a mask formed on a surface thereof, the mask having an aperture which defines an opening of the etched feature.

11. A method according to any previous claim in which the protective layer is a polymer.

12. A method according to any previous claim in which the scalloped profile comprises a plurality of scallops each having an associated height, and the smoothing of the scalloped profile of the sidewall comprises reducing the heights of the scallops; wherein optionally the heights of the scallops are reduced by at least 50%, preferably by at least 75%, more preferably by at least 90%.

13. A method of etching and treating a semiconductor substrate comprising the steps of:
placing the semiconductor substrate on a substrate support in an etch chamber;
performing an etch step by generating a plasma and using the plasma to etch a feature in the semiconductor substrate, the etched feature comprising a sidewall with a scalloped profile; and
performing a treatment step by generating a plasma in a gaseous atmosphere comprising Ar, O₂ and at least one per-fluorocarbon while applying an RF signal having an RF power to the substrate support, wherein the plasma (i) causes a protective layer formed at least partially from the per-fluorocarbon to be deposited on the sidewall and (ii) etches the sidewall so as to smooth the scalloped profile of the sidewall.

14. A method according to claim 13 comprising the further steps of:
performing a second etch step by generating a plasma and using the plasma to deepen the etched feature by etching a further section deeper into the semiconductor substrate, the further section comprising a sidewall with a scalloped profile; and
performing a second treatment step by generating a plasma in a gaseous atmosphere comprising Ar, O₂ and at least one per-fluorocarbon while applying an RF signal having an RF power to the substrate support, wherein the plasma (i) causes a protective layer formed at least partially from the per-fluorocarbon to be deposited on the sidewall of the further section and (ii) etches the sidewall of the further section so as to smooth the scalloped profile of the sidewall of the further section;
wherein optionally the steps of performing a second etch step and performing a second treatment step are alternated.

15. An etch apparatus for treating a semiconductor substrate comprising:
an etch chamber;
a substrate support in the etch chamber;
an RF source configured to supply an RF signal having an RF power to the substrate support;
at least one inlet for introducing a plurality of gases into the etch chamber; and
a controller configured to control the apparatus to perform a method according to any previous claim.
